# FASCICULE DE BREVET EUROPEEN

(11) **EP 3 075 023 B1**
(45) Date de publication et mention de la délivrance du brevet: **03.01.2018**
(21) Numéro de dépôt: 14793882.3
(22) Date de dépôt: 30.09.2014
(51) Int. Cl.: H01M 10/42, H01M 10/48, G01R 31/36, H02J 7/00, G01R 31/327

(54) **DETECTION DE DECONNEXION D'UNE CELLULE DANS UNE BATTERIE ELECTRIQUE**
ERKENNUNG DER UNTERBRECHUNG EINER ZELLE BEI EINER ELEKTRISCHEN BATTERIE
DETECTION OF DISCONNECTION OF A CELL IN AN ELECTRIC BATTERY

(30) Priorité: 28.11.2013 FR 1361771
(43) Date de publication de la demande: 05.10.2016
(73) Titulaire: Commissariat à l'Energie Atomique et aux Energies Alternatives, 75015 Paris (FR)
(72) Inventeur: FERNANDEZ, Eric, 38760 Saint Paul De Varces (FR); CHATROUX, Daniel, 38470 Teche (FR); DAUCHY, Julien, 73000 Chambéry (FR)
(74) Mandataire: Thibon, Laurent
(86) Numéro de dépôt international: PCT/FR2014/052459
(87) Numéro de publication internationale: WO 2015/079129

(56) Documents cités:
- EP-A2- 0 880 214
- WO-A1-2011/003924
- DE-A1-102011 115 550
- US-A1- 2002 051 904

## Description

La présente demande de brevet revendique la priorité de la demande de brevet français FR13/61771 qui sera considérée comme faisant partie intégrante de la présente description.

### Domaine

La présente demande concerne le domaine des batteries électriques de façon générale, et vise plus particulièrement un dispositif comportant une batterie électrique protégée contre des courts-circuits internes ou autres défaillances par des disjoncteurs, et un circuit de contrôle de cette batterie.

### Exposé de l'art antérieur

Une batterie électrique est un groupement de plusieurs cellules élémentaires rechargeables (piles, accumulateurs, etc.) reliées en série et/ou en parallèle entre deux noeuds ou bornes de fourniture de tension. A titre d'exemple, une batterie peut comprendre un ou plusieurs étages connectés en série entre ses bornes de fourniture de tension, chaque étage pouvant comporter une ou plusieurs cellules élémentaires connectées en parallèle. Le nombre d'étages de la batterie détermine alors le niveau de tension fourni par la batterie, et le nombre de cellules par étage détermine la capacité de la batterie et le courant susceptible d'être fourni par la batterie.

Pendant la durée de vie de la batterie, des défauts sont susceptibles d'apparaître sur certaines cellules élémentaires de la batterie. Un défaut sur une cellule se traduit généralement soit par la mise en court-circuit de la cellule, soit par l'apparition d'un courant de fuite important dans la cellule, soit par la mise en circuit ouvert de la cellule. En l'absence d'éléments de protection adaptés, la mise en court-circuit d'une cellule de la batterie peut avoir des conséquences graves, et peut provoquer une défaillance de l'ensemble de la batterie.

Pour protéger la batterie contre les conséquences de la mise en court-circuit d'une ou plusieurs de ses cellules élémentaires, on a proposé des batteries comportant des disjoncteurs placés sur des conducteurs d'interconnexion des cellules de la batterie.

En particulier, la demande de brevet internationale WO2011/003924 déposée par la demanderesse le 6 juillet 2010 et intitulée "Batterie d'accumulateurs à pertes réduites" (en anglais "Low-loss storage battery"), dont le contenu sera considéré comme faisant partie intégrante de la présente description, décrit une batterie électrique protégée contre les conséquences de la mise en court-circuit d'un ou plusieurs accumulateurs de la batterie, par des disjoncteurs placés sur des conducteurs d'interconnexion des accumulateurs de la batterie. Avantageusement, ces disjoncteurs sont placés en dehors du chemin de charge ou de décharge principal des accumulateurs de la batterie, sur des conducteurs d'interconnexion en parallèle des accumulateurs, qui ne sont parcourus que par des courants réduits en fonctionnement normal, c'est-à-dire lorsque tous les accumulateurs sont sains. Ceci permet d'utiliser des disjoncteurs de plus petit calibre et donc moins coûteux que lorsque les disjoncteurs sont placés en série avec les accumulateurs, sur le chemin de charge ou de décharge principal des accumulateurs en fonctionnement normal. En outre, ceci permet de limiter les pertes par effet Joule dans les disjoncteurs en fonctionnement normal.

Un problème qui se pose dans les batteries du type décrit dans la demande de brevet WO2011/003924 et, plus généralement, dans toute batterie comportant des disjoncteurs placés sur des conducteurs d'interconnexion en parallèle de cellules de la batterie, est celui de la détection d'une éventuelle déconnexion d'une cellule de la batterie par ouverture d'un ou plusieurs disjoncteurs de la batterie. La demande de brevet DE102011115550 décrit une batterie ayant au moins un premier étage comportant des cellules au lithium connectées en parallèle, des cellules connectées en série et au moins un disjoncteur.

### Résumé

Ainsi, un mode de réalisation prévoit un dispositif comportant : une batterie ayant au moins un premier étage comportant une pluralité de cellules connectées en parallèle par l'intermédiaire de premier et deuxième rails conducteurs, au moins un des premier et deuxième rails comportant au moins un disjoncteur situé sur une portion du rail connectant deux cellules voisines de l'étage ; et un circuit de contrôle comprenant un premier capteur de tension connecté entre une première extrémité du premier rail et une première extrémité du deuxième rail, et un deuxième capteur de tension connecté entre une deuxième extrémité du premier rail et une deuxième extrémité du deuxième rail, le circuit de contrôle étant adapté à comparer des valeurs de sortie des premier et deuxième capteurs.

Selon un mode de réalisation, le premier étage comprend au moins trois cellules élémentaires, et les cellules du premier étage ne sont connectées à aucun capteur de tension autre que les premier et deuxième capteurs.

Selon un mode de réalisation, au moins un des premier et deuxième rails du premier étage comporte un disjoncteur sur chaque portion du rail connectant deux cellules voisines de l'étage.

Selon un mode de réalisation, chacun des premier et deuxième rails du premier étage comporte un disjoncteur sur chaque portion du rail connectant deux cellules voisines de l'étage.

Selon un mode de réalisation, le dispositif comporte au moins un deuxième étage en série avec le premier étage.

Selon un mode de réalisation, le deuxième rail du premier étage et le premier rail du deuxième étage sont confondus.

Selon un mode de réalisation, le circuit de contrôle est adapté à connecter une charge entre la première extrémité du premier rail du premier étage et la première extrémité du deuxième rail du premier étage de façon à provoquer une décharge de cet étage.

Selon un mode de réalisation, le circuit de contrôle est adapté à appliquer une tension entre la première extrémité du premier rail du premier étage et la première extrémité du deuxième rail du premier étage de façon à provoquer une charge de cet étage.

Selon un mode de réalisation, le disjoncteur est un fusible.

Selon un mode de réalisation, les cellules sont des accumulateurs au lithium.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est un schéma électrique d'un exemple d'un dispositif comportant une batterie et un circuit de contrôle de cette batterie ; et
la figure 2 est un schéma électrique d'un exemple d'un mode de réalisation d'un dispositif comportant une batterie et un circuit de contrôle de cette batterie.

Par souci de clarté, de mêmes éléments ont été désignés par de mêmes références aux différentes figures.

### Description détaillée

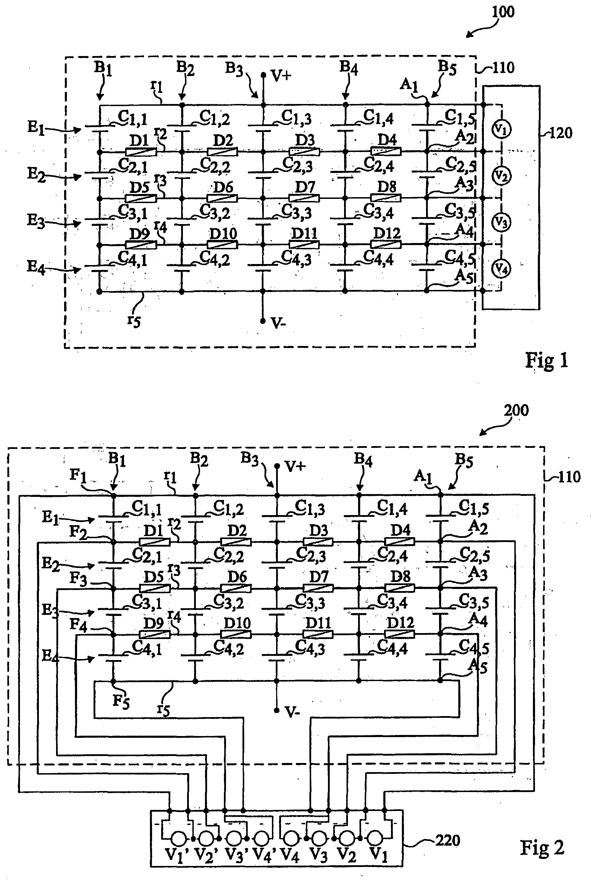

La figure 1 est un schéma électrique d'un exemple d'un dispositif 100 comportant une batterie 110 de vingt cellules élémentaires, et un circuit 120 de contrôle de cette batterie.

Dans cet exemple, les cellules de la batterie 110 sont disposées selon une matrice de quatre lignes et cinq colonnes, et sont désignées par les références C_{i,j}, où i est un entier allant de 1 à 4 désignant le rang de la ligne de la matrice à laquelle appartient la cellule, et j est un entier allant de 1 à 5 désignant le rang de la colonne de la matrice à laquelle appartient la cellule. Les cellules C_{i,j} sont par exemple des accumulateurs électrochimiques de type NiMH, présentant une tension nominale à l'état chargé de l'ordre de 1,2 V, des accumulateurs de type LiFePO₄, présentant une tension nominale à l'état chargé de l'ordre de 3,3 V, ou des accumulateurs de type LiCoO₂, présentant une tension nominale à l'état chargé de l'ordre de 4,2 V. Les modes de réalisation décrits ne se limitent toutefois pas à ces exemples particuliers de types de cellule.

Dans l'exemple représenté, les cellules d'une même ligne de la matrice sont connectées en parallèle et forment un étage Ei de la batterie (avec i entier allant de 1 à 4), et les cellules d'une même colonne de la matrice sont connectées en série et forment une branche Bj de la batterie. Plus particulièrement, dans cet exemple, dans chaque étage Eᵢ, les bornes positives des cellules de l'étage sont connectées ensemble par l'intermédiaire d'un rail ou fil conducteur rᵢ, et les bornes négatives des cellules de l'étage sont connectées ensemble par l'intermédiaire d'un rail ou fil conducteur rᵢ₊₁. Ainsi, dans cet exemple, un même rail conducteur rᵢ₊₁ est utilisé pour connecter ensemble les bornes négatives des cellules de l'étage Ei et les bornes positives des cellules de l'étage Eᵢ₊₁. Les modes de réalisation décrits ne se limitent toutefois pas à cette façon particulière de connecter en parallèle les cellules d'un même étage et de connecter en série les différents étages de la batterie.

La batterie 110 comprend en outre des bornes positive et négative de fourniture de tension V+ et V-, respectivement connectées au rail connectant ensemble les bornes positives du premier étage de la batterie, le rail r₁ dans cet exemple, et au rail connectant ensemble les bornes négatives du dernier étage de la batterie, le rail r₅ dans cet exemple.

Pour protéger la batterie contre les conséquences de la mise en court-circuit d'une cellule C_{i,j} de la batterie, la batterie 110 comprend des disjoncteurs, par exemple des fusibles, placés sur les rails conducteurs de connexion en parallèle des cellules de la batterie. De préférence, les disjoncteurs sont placés de façon que, dans chaque étage Ei de la batterie, au moins un des deux rails conducteurs rᵢ et rᵢ₊₁ par l'intermédiaire desquels les cellules de l'étage sont connectées en parallèle, comporte au moins un disjoncteur, et de préférence un disjoncteur par portion de rail connectant deux cellules successives de l'étage.

Dans l'exemple de la figure 1 _{:} les rails r₁ et r₅ ne comprennent pas de disjoncteur ; le rail r₂ comprend un disjoncteur D1 sur la portion de rail connectant les cellules C_{1,1} et C_{2,1} d'une part, aux cellules C_{1,2} et C_{2,2} d'autre part, un disjoncteur D2 sur la portion de rail connectant les cellules C_{1,2} et C_{2,2} d'une part, aux cellules C_{1,3} et C₂,₃ d'autre part, un disjoncteur D3 sur la portion de rail connectant les cellules C_{1,3} et C_{2,3} d'une part, aux cellules C_{1,4} et C_{2,4} d'autre part, et un disjoncteur D4 sur la portion de rail connectant les cellules _{C1,4} et C_{2,4} d'une part, aux cellules C_{1,5} et C_{2,5} d'autre part ; le rail r₃ comprend un disjoncteur D5 sur la portion de rail connectant les cellules C_{2,1} et C_{3,1} d'une part, aux cellules C_{2,2} et C_{3,2} d'autre part, un disjoncteur D6 sur la portion de rail connectant les cellules C_{2,2} et C_{3,2} d'une part, aux cellules C_{2,3} et C_{3,3} d'autre part, un disjoncteur D7 sur la portion de rail connectant les cellules C_{2,3} et C_{3,3} d'une part, aux cellules C_{2,4} et C_{3,4} d'autre part, et un disjoncteur D8 sur la portion de rail connectant les cellules C_{2,4} et C_{3,4} d'une part, aux cellules C_{2,5} et C_{3,5} d'autre part ; et le rail r₄ comprend un disjoncteur D9 sur la portion de rail connectant les cellules C_{3,1} et C_{4,1} d'une part, aux cellules C_{3,2} et C_{4,2} d'autre part, un disjoncteur D10 sur la portion de rail connectant les cellules C_{3,2} et C_{4,2} d'une part, aux cellules C_{3,3} et C_{4,3} d'autre part, un disjoncteur D11 sur la portion de rail connectant les cellules C_{3,3} et C_{4,3} d'une part, aux cellules C_{3,4} et C_{4,4} d'autre part, et un disjoncteur D12 sur la portion de rail connectant les cellules C_{3,4} et C_{4,4} d'une part, aux cellules C_{3,5} et C_{4,5} d'autre part.

En d'autres termes, dans l'exemple de la figure 1, chacun des rails conducteurs par l'intermédiaire desquels des cellules d'un étage de la batterie sont connectées en parallèle, à l'exception des rails connectés aux bornes de fourniture de tension V+ et V- de la batterie, comporte un disjoncteur sur chaque portion du rail connectant deux cellules voisines d'un même étage de la batterie. Les modes de réalisation décrits ne se limitent toutefois pas à ce cas particulier. A titre de variante, seul un rail sur deux pourrait être équipé de disjoncteurs (par exemple, dans l'exemple de la figure 1, le rail r₃ pourrait être dépourvu de disjoncteurs). Par ailleurs, les premier et dernier rails de la batterie (les rails r₁ et r₅ dans cet exemple), pourraient être équipés de disjoncteurs.

Le circuit 120 peut être adapté à réaliser diverses fonctions telles que des fonctions d'équilibrage et de contrôle de charge des cellules de la batterie. Le contrôle de charge d'une cellule s'effectue généralement par une mesure de tension. Lorsque plusieurs cellules sont connectées en parallèle dans une batterie, une seule mesure de tension par groupe de cellules en parallèle peut suffire, puisque la connexion en parallèle impose une même tension aux bornes de toutes les cellules du groupe.

Dans l'exemple de la figure 5, le circuit de contrôle 120 comprend, pour chaque étage Ei de la batterie, un circuit de mesure de tension ou capteur de tension Vᵢ, connecté à une extrémité de l'étage Eᵢ, l'extrémité droite dans l'exemple représenté c'est-à-dire côté branche B₅ de la matrice de cellules. Plus particulièrement, dans cet exemple, chaque capteur Vi est connecté à des extrémités Aᵢ et Aᵢ₊₁ des rails rᵢ et rᵢ₊₁ respectivement, c'est-à-dire des points ou noeuds des rails rᵢ et rᵢ₊₁ situés au niveau des bornes de la dernière cellule C_{i,5} de l'étage, ou du côté des bornes de la cellule C_{i,5} opposé aux branches B₁ à B₄ de la batterie. Chaque capteur Vᵢ est adapté à mesurer la tension de l'étage Eᵢ entre les extrémités Aᵢ et Aᵢ₊₁ des rails rᵢ et rᵢ₊₁ respectivement.

A titre d'exemple, les disjoncteurs Dk, avec k entier allant de 1 à 12, de la batterie 110 sont dimensionnés de façon qu'en cas de défaillance d'une cellule de la batterie, provoquant la mise en court-circuit de cette cellule, des disjoncteurs voisins de la cellule défaillante, par exemple tous les disjoncteurs directement connectés à cette cellule, s'ouvrent sous l'effet de l'apparition, dans ces disjoncteurs, de forts courants résultants de la décharge de cellules saines dans la cellule défaillante. Ceci permet de déconnecter ou isoler la cellule défaillante du reste de l'étage auquel elle appartient, avant que les cellules saines de l'étage ne se déchargent entièrement dans la cellule défaillante.

Par exemple, les disjoncteurs D1 à D12 peuvent être dimensionnés de façon que, si la cellule C_{3,2} se met en court-circuit, les disjoncteurs D5, D6, D9 et D10 s'ouvrent pour isoler cette cellule du reste de l'étage E₃.

Une fois la cellule défaillante isolée, la batterie peut continuer de fonctionner pendant un certain nombre de cycles, avec une capacité totale réduite du fait de la déconnexion de la cellule défaillante, mais avec une tension à ses bornes inchangée.

Il serait souhaitable que le circuit de contrôle de batterie 120 puisse détecter une déconnexion d'une cellule élémentaire par ouverture d'un ou plusieurs des disjoncteurs Dk, pour pouvoir signaler à l'utilisateur qu'une réparation serait souhaitable. La réparation pourra par exemple consister à changer la cellule défaillante et/ou un ou plusieurs disjoncteurs.

Dans l'exemple susmentionné dans lequel la cellule C_{3,2} est considérée défaillante, la déconnexion de cette cellule du reste de l'étage E₃ par ouverture des disjoncteurs D5, D6, D9 et D10, n'entraine pas de variation significative de la tension vue par le capteur de tension V₃, puisque les cellules saines C_{3,3}, C_{3,4} et C_{3,5} de l'étage E₃ continuent de délivrer aux bornes du capteur V₃ une tension sensiblement égale à la tension d'une cellule élémentaire.

Plus généralement, en cas de défaillance et déconnexion d'une cellule élémentaire de la batterie 110, si la cellule défaillante n'est pas directement connectée à l'un des capteurs de tension du circuit 120, c'est-à-dire si elle ne fait pas partie de la branche B₅ de la batterie dans l'exemple de la figure 1, la défaillance n'est pas directement détectable par les capteurs de tension Vᵢ du circuit de contrôle 120.

Une solution pour permettre de détecter une défaillance d'une cellule quelconque de la batterie serait de prévoir un circuit de contrôle 120 comportant un capteur de tension par cellule élémentaire de la batterie. Le coût et l'encombrement d'un tel circuit de contrôle est toutefois incompatible avec certaines applications.

Une autre solution pour détecter la déconnexion d'une cellule quelconque de la batterie serait de mesurer à intervalles réguliers, au moyen du circuit de contrôle 120, la capacité totale de la batterie, afin de détecter une éventuelle diminution de capacité correspondant à la déconnexion d'une ou plusieurs cellules. Les opérations de mesure de capacité totale de la batterie sont toutefois complexes et contraignantes, et nécessitent notamment de décharger totalement ou partiellement la batterie en mesurant simultanément, au moyen d'un compteur de courant, la vitesse de décharge de la batterie.

Ainsi, il serait souhaitable de pouvoir disposer d'une solution fiable, simple, peu coûteuse et peu encombrante, permettant de détecter une ouverture d'un ou plusieurs disjoncteurs dans une batterie électrique comportant des disjoncteurs placés sur des éléments de connexion en parallèle de cellules de la batterie.

La figure 2 est un schéma électrique d'un exemple d'un mode de réalisation d'un dispositif 200 comportant une batterie électrique comportant des disjoncteurs placés sur des éléments de connexion en parallèle de cellules de la batterie, par exemple une batterie du type décrit en relation avec la figure 1, et un circuit 220 de contrôle de cette batterie. Dans l'exemple représenté, la batterie 110 du dispositif 200 de la figure 2 est identique à la batterie 110 du dispositif 100 de la figure 1, et ne sera pas décrite à nouveau en détail.

Le circuit 220 peut être adapté à réaliser diverses fonctions telles que des fonctions d'équilibrage et de contrôle de charge des cellules de la batterie.

Selon un aspect, le circuit 220 comprend, pour chaque étage de cellules en parallèle de la batterie, deux circuits de mesure de tension ou capteurs de tension destinés à être connectés respectivement aux deux extrémités opposées de l'étage.

Dans l'exemple de la figure 2, pour chaque étage Eᵢ de la batterie, le circuit 220 comprend, comme le circuit 120 de la figure 1, un capteur de tension Vᵢ connecté à une extrémité de l'étage Eᵢ, l'extrémité droite dans l'exemple représenté (côté branche B₅ de la matrice de cellules). Plus particulièrement, dans cet exemple, chaque capteur Vᵢ est connecté aux extrémités Aᵢ et Aᵢ₊₁ des rails rᵢ et rᵢ₊₁ respectivement, c'est-à-dire en des points ou noeuds des rails rᵢ et rᵢ₊₁ situés au niveau des bornes de la dernière cellule C_{i,5} de l'étage, ou du côté des bornes de la cellule C_{i,5} opposé aux branches B₁ à B₄ de la batterie.

De plus, dans l'exemple de la figure 2, pour chaque étage Ei de la batterie, le circuit 220 comprend un capteur de tension Vᵢ' connecté à une extrémité de l'étage Ei opposée au capteur Vᵢ, l'extrémité gauche dans l'exemple représenté (côté branche B₁ de la matrice de cellules). Plus particulièrement, dans cet exemple, chaque capteur Vᵢ' est connecté à des extrémités Fᵢ et Fᵢ₊₁ des rails rᵢ et rᵢ₊₁ respectivement, c'est-à-dire des points ou noeuds des rails rᵢ et rᵢ₊₁ situés au niveau des bornes de la première cellule C_{i,1} de l'étage, ou du côté des bornes de la cellule C_{i,1} opposé aux branches B₂ à B₅ de la batterie.

Chaque capteur Vᵢ est adapté à mesurer la tension de l'étage Ei entre les extrémités Aᵢ et Aᵢ₊₁ des rails rᵢ et rᵢ₊₁ respectivement, et chaque capteur Vᵢ' est adapté à mesurer la tension de l'étage Ei entre les extrémités Fᵢ et Fᵢ₊₁ des rails rᵢ et rᵢ₊₁ respectivement.

Dans un Ei étage donné, lorsque tous les disjoncteurs des rails rᵢ et rᵢ₊₁ de l'étage sont fermés (passants), ce qui correspond au fonctionnement normal de la batterie, les tensions mesurées par les capteurs Vᵢ et Vᵢ' aux deux extrémités de l'étage sont strictement identiques, aux dispersions de mesure des capteurs près. Par contre, si un ou plusieurs disjoncteurs des rails rᵢ et rᵢ₊₁ est ouvert (non passant), les tensions mesurées par les capteurs Vᵢ et Vᵢ' aux deux extrémités de l'étage sont susceptibles d'évoluer différemment dans le temps.

Selon un aspect, le circuit 220 est adapté à comparer, pour chaque étage Ei de la batterie, les tensions mesurées par les capteurs Vᵢ et Vᵢ' aux deux extrémités de l'étage. Lorsqu'une différence, même minime mais supérieure à la dispersion maximale de mesure des capteurs, par exemple une différence supérieure à 10 mV, apparaît entre les valeurs de sortie des capteurs Vᵢ et Vᵢ', cela signifie qu'au moins un disjoncteur des rails rᵢ et/ou rᵢ₊₁ a été ouvert, et le circuit 220 peut signaler une anomalie.

Dans le cas d'exemple illustratif susmentionné dans lequel la cellule C_{3,2} est déconnectée du reste de l'étage E₃ par ouverture des disjoncteurs D5, D6, D9 et D10, la déconnexion de la cellule peut, dans un premier temps, ne pas entrainer de variation significative de la tension vue par les capteurs de V₃ et V₃', puisque les cellules saines C_{3,3}, C_{3,4} et C_{3,5} continuent de délivrer aux bornes du capteur V₃ une tension sensiblement égale à la tension d'une cellule élémentaire, et que la cellule saine C_{3,1} continue de délivrer aux bornes du capteur V₃' une tension sensiblement égale à la tension d'une cellule élémentaire. Toutefois, du fait de l'ouverture des disjoncteurs D5, D6, D9 et D10, la tension mesurée par le capteur V₃ peut évoluer différemment de la tension mesurée par le capteur V₃' en fonction de l'utilisation qui est faite de la batterie. Différents paramètres peuvent provoquer l'apparition d'une différence de tension détectable par le circuit 120 entre les deux extrémités de l'étage E₃, par exemple des différences de résistance interne des cellules de l'étage, liées à des dispersions de fabrication, des différences de température dans l'étage, des différences de régime de courant, etc. La dérive de la tension mesurée par le capteur V₃' par rapport à la tension mesurée par le capteur V₃ peut être plus ou moins rapide. Toutefois, les inventeurs ont constaté qu'une différence de tension significative, par exemple supérieure à 10 mV, représentative d'une ouverture d'au moins un disjoncteur de l'étage, peut pratiquement toujours être détectée après un certain temps.

Le circuit 220 peut par exemple être configuré pour comparer régulièrement, pour chaque étage Ei de la batterie, les tensions mesurées par les capteurs Vᵢ et Vᵢ' aux deux extrémités de l'étage.

A titre de variante, pour faciliter la détection d'une éventuelle déconnexion d'une cellule d'un étage Eᵢ, le circuit 220 peut être configuré pour provoquer activement une variation de la tension entre les rails rᵢ et rᵢ₊₁ par l'intermédiaire d'une seule extrémité de l'étage, et mesurer simultanément la tension entre les rails rᵢ et rᵢ₊₁ à l'autre extrémité de l'étage afin de vérifier si la variation provoquée s'y retrouve à l'identique. Pour provoquer une variation de tension via une extrémité de l'étage, le circuit 220 peut par exemple provoquer une consommation ou une fourniture de courant entre les rails rᵢ et rᵢ₊₁ via cette extrémité de l'étage. A titre d'exemple, le circuit 220 peut connecter un élément résistif entre les rails rᵢ et rᵢ₊₁ à une seule extrémité de l'étage pour provoquer une consommation de courant dans l'étage et faire ainsi chuter la tension entre les rails rᵢ et rᵢ₊₁, vue depuis cette extrémité de l'étage. Si la tension mesurée par le circuit 220 à l'autre extrémité de l'étage ne subi pas la même chute, on peut en déduire qu'au moins un disjoncteur de l'étage est ouvert. On notera que l'élément résistif utilisé peut être un élément déjà prévu dans le circuit de contrôle 220 pour réaliser d'autres fonctions telles que des fonctions d'équilibrage de charge. Alternativement, le circuit 220 peut réaliser un transfert d'énergie depuis un autre étage de la batterie vers l'étage Eᵢ, de façon à faire croître la tension entre les rails rᵢ et rᵢ₊₁, vue depuis une extrémité de l'étage. Si la tension mesurée par le circuit 220 à l'autre extrémité de l'étage ne subit pas la même croissance, on peut en déduire qu'au moins un disjoncteur de l'étage est ouvert.

Cette variante de réalisation permet, de détecter des déconnexions même dans des cas défavorables, c'est-à-dire lorsque la dérive entre les tensions mesurées aux deux extrémités d'un étage Ei comportant une cellule déconnectée est très lente, par exemple lorsque la cellule déconnectée se situe au centre de l'étage, et que tous les accumulateurs sont strictement identiques en termes de performances (résistance interne, capacité, échauffement, etc.).

Un avantage du mode de réalisation de la figure 2 est qu'il permet, de façon simple, fiable, peu coûteuse, peu encombrante, et relativement rapide, de détecter une ouverture d'un ou plusieurs disjoncteurs dans une batterie électrique comportant des disjoncteurs placés sur des éléments de connexion en parallèle de cellules de la batterie.

Le surcoût et l'encombrement liés à la présence de capteurs de tension supplémentaires sont faibles puisqu'il suffit d'ajouter au circuit de contrôle un seul capteur de tension par étage de la batterie par rapport à un dispositif du type décrit en relation avec la figure 1.

On notera de plus que dans de nombreux domaines, les circuits de contrôle de batterie doivent comporter des éléments redondants, et notamment des capteurs de tension redondants, de façon à pouvoir continuer de fonctionner en cas de défaillance d'un capteur. Dans la solution proposée, les capteurs de tension Vᵢ et Vᵢ' d'un étage Ei peuvent servir à la fois à détecter une éventuelle anomalie de mesure (fonction de redondance) et à détecter une ouverture de disjoncteur.

Un autre avantage des modes de réalisation décrits est qu'ils permettent de détecter une ouverture accidentelle d'un fusible même en l'absence de défaut sur une cellule de la batterie.

Des modes de réalisation particuliers ont été décrits. Diverses variantes et modifications apparaîtront à l'homme de l'art.

En particulier, les modes de réalisation décrits ne se limitent pas au cas où les disjoncteurs placés sur des éléments de connexion en parallèle de cellules de la batterie sont des fusibles. Plus généralement, dans la présente demande, un disjoncteur est défini comme étant un dispositif de protection électrique adapté à interrompre ou limiter très fortement, par exemple par un facteur 100, le courant électrique le traversant en cas de surcharge sur un circuit électrique.

De plus, les modes de réalisation ne se limitent pas à l'exemple particulier de schéma de batterie des figures 1 et 2. Plus généralement, l'homme de l'art saura mettre en oeuvre le fonctionnement recherché dans toute batterie comportant au moins un étage, et de préférence au moins deux étages, chaque étage comportant au moins deux cellules en parallèle, et de préférence au moins trois cellules en parallèle.

## Revendications

1. Dispositif (200) comportant une batterie (110) ayant au moins un premier étage (Eᵢ) comportant une pluralité de cellules (C_{i,j}) connectées en parallèle par l'intermédiaire de premier (rᵢ) et deuxième (rᵢ₊₁) rails conducteurs, au moins un des premier (rᵢ) et deuxième (rᵢ₊₁) rails comportant au moins un disjoncteur (Dk) situé sur une portion du rail connectant deux cellules voisines (C_{i,j}, C_{i,j+1}) de l'étage, **caractérisé en ce qu'**il comprend en outre un circuit de contrôle (220) comprenant un premier capteur de tension (Vᵢ) connecté entre une première extrémité (Aᵢ) du premier rail (rᵢ) et une première extrémité (Aᵢ₊₁) du deuxième rail (rᵢ₊₁), et un deuxième capteur de tension (Vᵢ') connecté entre une deuxième extrémité (Fᵢ) du premier rail (rᵢ) et une deuxième extrémité (Fᵢ₊₁) du deuxième rail (rᵢ₊₁), le circuit de contrôle (220) étant adapté à comparer des valeurs de sortie des premier (Vᵢ) et deuxième (Vᵢ') capteurs.

2. Dispositif (200) selon la revendication 1, dans lequel le premier étage (Eᵢ) comprend au moins trois cellules élémentaires (C_{i,j}), et dans lequel les cellules (C_{i,j}) du premier étage ne sont connectées à aucun capteur de tension autre que les premier (Vᵢ) et deuxième (Vᵢ') capteurs.

3. Dispositif (200) selon la revendication 1 ou 2, dans lequel au moins un des premier (rᵢ) et deuxième (rᵢ₊₁) rails du premier étage (Eᵢ) comporte un disjoncteur sur chaque portion du rail connectant deux cellules voisines (C_{i,j}, C_{i,j+1}) de l'étage.

4. Dispositif (200) selon la revendication 1 ou 2, dans lequel chacun des premier (rᵢ) et deuxième (rᵢ₊₁) rails du premier étage (Eᵢ) comporte un disjoncteur sur chaque portion du rail connectant deux cellules voisines (C_{i,j}, C_{i,j+1}) de l'étage.

5. Dispositif (200) selon l'une quelconque des revendications 1 à 4, comportant au moins un deuxième étage (Eᵢ₊₁) en série avec le premier étage (Eᵢ).

6. Dispositif (200) selon la revendication 5, dans lequel le deuxième rail (rᵢ₊₁) du premier étage et le premier rail (rᵢ₊₁) du deuxième étage (Eᵢ₊₁) sont confondus.

7. Dispositif (200) selon l'une quelconque des revendications 1 à 6, dans lequel le circuit de contrôle (220) est adapté à connecter une charge entre la première extrémité (Aᵢ) du premier rail (rᵢ) du premier étage (Eᵢ) et la première extrémité (Aᵢ₊₁) du deuxième rail (rᵢ₊₁) du premier étage (Eᵢ) de façon à provoquer une décharge de cet étage (Eᵢ).

8. Dispositif (200) selon l'une quelconque des revendications 1 à 7, dans lequel le circuit de contrôle (220) est adapté à appliquer une tension entre la première extrémité (Aᵢ) du premier rail (rᵢ) du premier étage (Eᵢ) et la première extrémité (Aᵢ₊₁) du deuxième rail (rᵢ₊₁) du premier étage (Eᵢ) de façon à provoquer une charge de cet étage.

9. Dispositif (200) selon l'une quelconque des revendications 1 à 8, dans lequel ledit au moins un disjoncteur (Dk) est un fusible.

10. Dispositif (200) selon l'une quelconque des revendications 1 à 9, dans lequel lesdites cellules (C_{i,j}) sont des accumulateurs au lithium.

## Patentansprüche

1. Eine Vorrichtung (200), die eine Batterie (110) aufweist, welche mindestens eine erste Stufe (Eᵢ) besitzt, die eine Vielzahl von Zellen (C_{i,j}) aufweist, welche parallel über erste (rᵢ) und zweite (rᵢ₊₁) Leiterschienen verbunden sind, wobei mindestens eine der ersten (rᵢ) und zweiten (rᵢ₊₁) Schienen mindestens einen Schaltungsunterbrecher (Dk) aufweist, der an einem Teil der Schiene, der zwei benachbarte Zellen (C_{i,j}, C_{i, j+1}) der Stufen verbindet, angeordnet ist, **dadurch gekennzeichnet, dass** sie ferner eine Steuerschaltung (220) aufweist, die einen ersten Spannungssensor (Vᵢ) aufweist, der zwischen einem ersten Ende (Aᵢ) der ersten Schiene (rᵢ) und einem ersten Ende (Aᵢ₊₁) der zweiten Schiene (rᵢ₊₁) verbunden ist, und ein zweiter Spannungssensor (Vᵢ'), der zwischen einem zweiten Ende (Fᵢ) der ersten Schiene (rᵢ) und einem zweiten Ende (Fᵢ₊₁) der zweiten Schiene (rᵢ₊₁) verbunden ist, wobei die Steuerschaltung (220) geeignet ist, Ausgangswerte der ersten (Vᵢ) und zweiten (Vᵢ') Sensoren zu vergleichen.

2. Vorrichtung (200) nach Anspruch 1, wobei die erste Stufe (Eᵢ) mindestens drei Elementarzellen (C_{i,j}) aufweist und wobei die Zellen (C_{i,j}) der ersten Stufe mit keinem anderen Spannungssensor als den ersten (Vᵢ) und zweiten (Vᵢ') Sensoren verbunden sind.

3. Vorrichtung (200) nach Anspruch 1 oder 2, wobei mindestens eine der ersten (rᵢ) und zweiten (rᵢ₊₁) Schienen der ersten Stufe (Eᵢ) einen Schaltungsunterbrecher an jedem Teil der Schiene aufweist, die zwei benachbarte Zellen (C_{i,j}, C_{i,j+1}) der Stufe verbinden.

4. Vorrichtung (200) nach Anspruch 1 oder 2, wobei jede der ersten (rᵢ) und zweiten (rᵢ₊₁) Schienen der ersten Stufe (Eᵢ) einen Schaltungsunterbrecher an jedem Teil der Schiene aufweist, die zwei benachbarte Zellen (C_{i,j}, C_{i,j+1}) der Stufe verbinden.

5. Vorrichtung (200) nach einem der Ansprüche 1 bis 4, die mindestens eine zweite Stufe (Eᵢ₊₁) in Reihe mit der ersten Stufe (Eᵢ) aufweist.

6. Vorrichtung (200) nach Anspruch 5, wobei die zweite Schiene (rᵢ₊₁) der ersten Stufe und die erste Schiene (rᵢ₊₁) der zweiten Stufe (Eᵢ₊₁) ein und dieselbe ist.

7. Vorrichtung (200) nach einem der Ansprüche 1 bis 6, wobei die Steuerschaltung (220) geeignet ist, eine Last zwischen dem ersten Ende (Aᵢ) der ersten Schiene (rᵢ) der ersten Stufe (Eᵢ) und dem ersten Ende (Aᵢ₊₁) der zweiten Schiene (rᵢ₊₁) der ersten Stufe (Eᵢ) zu verbinden, um eine Entladung dieser Stufe (Eᵢ) zu bewirken.

8. Vorrichtung (200) nach einem der Ansprüche 1 bis 7, wobei die Steuerschaltung (220) geeignet ist, eine Spannung zwischen dem ersten Ende (Aᵢ) der ersten Schiene (rᵢ) der ersten Stufe (Eᵢ) und dem ersten Ende (Aᵢ₊₁) der zweiten Schiene(rᵢ₊₁) der ersten Stufe (Eᵢ) anzulegen, um eine Entladung dieser Stufe zu bewirken.

9. Vorrichtung (200) nach einem der Ansprüche 1 bis 8, wobei der mindestens eine Schaltungsunterbrecher (Dk) eine Sicherung ist.

10. Vorrichtung (200) nach einem der Ansprüche 1 bis 9, wobei die Zellen (C_{i,j}) Lithiumbatterien sind.

## Claims

1. A device (200) comprising a battery (110) having at least a first stage (Eᵢ) comprising a plurality of cells (C_{i,j}) connected in parallel via first (rᵢ) and second (rᵢ₊₁) conductive rails, at least one of the first (rᵢ) and second (rᵢ₊₁) rails comprising at least one circuit breaker (Dk) located on a portion of the rail connecting two neighboring cells (C_{i,j}, C_{i,j+1}) of the stage, **characterized in that** it further comprises a control circuit (220) comprising a first voltage sensor (Vᵢ) connected between a first end (Aᵢ) of the first rail (rᵢ) and a first end (Aᵢ₊₁) of the second rail (rᵢ₊₁), and a second voltage sensor (Vᵢ') connected between a second end (Fᵢ) of the first rail (rᵢ) and a second end (Fᵢ₊₁) of the second rail (rᵢ₊₁), the control circuit (220) being capable of comparing output values of the first (Vᵢ) and second (Vᵢ') sensors.

2. The device (200) of claim 1, wherein the first stage (Eᵢ) comprises at least three elementary cells (C_{i,j}) and wherein the cells (C_{i,j}) of the first stage are connected to no voltage sensor other than the first (Vᵢ) and second (Vᵢ') sensors.

3. The device (200) of claim 1 or 2, wherein at least one of the first (rᵢ) and second (rᵢ₊₁) rails of the first stage (Eᵢ) comprises a circuit breaker on each portion of the rail connecting two neighboring cells (C_{i,j}, C_{i,j+1}) of the stage.

4. The device (200) of claim 1 or 2, wherein each of the first (rᵢ) and second (rᵢ₊₁) rails of the first stage (Eᵢ) comprises a circuit breaker on each portion of the rail connecting two neighboring cells (C_{i,j}, C_{i,j+1}) of the stage.

5. The device (200) of any of claims 1 to 4, comprising at least one second stage (Eᵢ₊₁) in series with the first stage (Eᵢ).

6. The device (200) of claim 5, wherein the second rail (rᵢ₊₁) of the first stage and the first rail (rᵢ₊₁) of the second stage (Eᵢ₊₁) are one and the same.

7. The device (200) of any of claims 1 to 6, wherein the control circuit (220) is capable of connecting a load between the first end (Aᵢ) of the first rail (rᵢ) of the first stage (Eᵢ) and the first end (Aᵢ₊₁) of the second rail (rᵢ₊₁) of the first stage (Eᵢ) to cause a discharge of this stage (Eᵢ).

8. The device (200) of any of claims 1 to 7, wherein the control circuit (220) is capable of applying a voltage between the first end (Aᵢ) of the first rail (rᵢ) of the first stage (Eᵢ) and the first end (Aᵢ₊₁) of the second rail (rᵢ₊₁) of the first stage (Eᵢ) to cause a discharge of this stage.

9. The device (200) of any of claims 1 to 8, wherein said at least one circuit breaker (Dk) is a fuse.

10. The device (200) of any of claims 1 to 9, wherein said cells (C_{i,j}) are lithium batteries.
